(19) Europäisches Patentamt
European Patent Office
Office européen des brevets

(11) **EP 4 484 993 A1**

(12) **EUROPÄISCHE PATENTANMELDUNG**

(43) Veröffentlichungstag:
**01.01.2025 Patentblatt 2025/01**

(21) Anmeldenummer: 23181787.5

(22) Anmeldetag: **27.06.2023**

(51) Internationale Patentklassifikation (IPC):
**G01R 33/483** (2006.01)   **G01R 33/54** (2006.01)
**G01R 33/24** (2006.01)   **G01R 33/50** (2006.01)

(52) Gemeinsame Patentklassifikation (CPC):
**G01R 33/4835; G01R 33/543;** G01R 33/243;
G01R 33/246; G01R 33/50

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**KH MA MD TN**

(71) Anmelder:
• **Siemens Healthineers AG**
**91301 Forchheim (DE)**

• **Universitätsklinikum Erlangen**
**91054 Erlangen (DE)**

(72) Erfinder:
• **Eisen, Christian**
**90402 Nürnberg (DE)**
• **Grodzki, David**
**91058 Erlangen (DE)**

(74) Vertreter: **Siemens Healthineers
Patent Attorneys
Postfach 22 16 34
80506 München (DE)**

(54) **VERFAHREN ZUR ERMITTLUNG ZUMINDEST EINES PULSES EINER MAGNETRESONANZSEQUENZ**

(57)    Die Erfindung betrifft Verfahren zur Ermittlung zumindest eines Pulses einer Magnetresonanzsequenz, eine Magnetresonanzvorrichtung und ein Computerprogrammprodukt. Das Verfahren umfasst ein Bereitstellen mehrerer Eingangsparameter, wobei jeder der zu messenden Schichten jeweils zumindest ein Eingangsparameter der mehreren Eingangsparameter zugeordnet ist, ein Identifizieren mehrerer Schichtblöcke, wobei jedem der mehreren Schichtblöcke zumindest eine Schicht der mehreren zu messenden Schichten zugeordnet ist, wobei die Eingangsparameter der Schichten desselben Schichtblocks zumindest ein Ähnlichkeitskriterium erfüllen, und ein schichtblockweises Ermitteln zumindest eines Pulses der Magnetresonanzsequenz zur Verwendung für alle Schichten des jeweiligen Schichtblocks.

FIG 3

EP 4 484 993 A1

**Beschreibung**

Die Erfindung betrifft ein Verfahren zur Ermittlung zumindest eines Pulses einer Magnetresonanzsequenz, eine Magnetresonanzvorrichtung und ein Computerprogrammprodukt.

In der Medizintechnik zeichnet sich die Bildgebung mittels Magnetresonanz (MR), auch Magnetresonanztomographie (MRT, engl. Magnetic Resonance Imaging, MRI) genannt, durch hohe Weichteilkontraste aus. Ein Untersuchungsobjekt wird dabei in einem Untersuchungsbereich einer Magnetresonanzvorrichtung mit einem statischen Hauptmagnetfeld (auch B0-Feld genannt) positioniert. Während einer Magnetresonanzmessung werden zur Anregung der zu messenden Schichten Pulse gemäß einer Magnetresonanzsequenz in den Untersuchungsbereich eingestrahlt. Solche Pulse können insbesondere hochfrequente (HF, engl. radiofrequency, RF) Pulse zur Erzeugung eines HF-Feldes (auch B1-Feld genannt) und/oder Gradientenpulse zur Erzeugung eines magnetischen Feldgradienten umfassen. Dadurch werden im Untersuchungsobjekt ortskodierte Magnetresonanzsignale ausgelöst. Die Magnetresonanzsignale werden als Messdaten von der Magnetresonanzvorrichtung empfangen und zur Rekonstruktion von Magnetresonanzabbildungen verwendet.

Als HF-Pulse werden heutzutage vor allem mehr oder weniger statische Pulse verwendet, z.B. Sinc-Pulse, die sich für eine Messung nur in Phase, Frequenz, Bandweite und/oder Amplitude unterscheiden. Neben diesen Pulsen gibt es auch sogenannte dynamische Pulse, insbesondere Mehrkanal- bzw. pTx-Pulse, die sich an bestimmte B0-Feldverteilungen, B1-Feldverteilungen oder Zielzustände im Ortsraum anpassen. Beispiele kann mittels pTx-Pulsen eine gleichmäßige B1-Feldverteilung, ein gezieltes Anregen von Mustern im Untersuchungsobjekt (z.B. Schachbrettmuster) und/oder eine an eine vorliegende B0-Feldverteilung anpasste Fettsättigung erreicht werden.

Die Vorbereitungs- und Berechnungsdauer eines dynamischen Pulses vor Ausführung der Magnetresonanzsequenz ist sehr hoch. Sie liegt üblicherweise in einem Bereich von wenigen Sekunden bis zu 30 Sekunden pro Schicht. Insbesondere für Messungen mit vielen Schichten kann sich in Summe eine inakzeptabel lange Rechenzeit ergeben.

Als Aufgabe der vorliegenden Erfindung kann angesehen werden, die benötigte Zeit zur Ermittlung der Pulse zu reduzieren, die für die Messung mehrerer Schichten nötig sind. Die Aufgabe wird durch die Merkmale der unabhängigen Ansprüche gelöst. Vorteilhafte Ausgestaltungen sind in den abhängigen Ansprüchen beschrieben. Unabhängig vom grammatikalischen Geschlecht eines bestimmten Begriffes sind Personen mit männlicher, weiblicher oder anderer Geschlechteridentität mit umfasst.

Demnach wird ein, insbesondere computerimplementiertes, Verfahren zur Ermittlung zumindest eines Pulses einer Magnetresonanzsequenz vorgeschlagen. Mit dem zumindest einen Puls der Magnetresonanzsequenz sollen mehrere Schichten, insbesondere eines Untersuchungsobjekts, gemäß der Magnetresonanzsequenz gemessen werden. Das Untersuchungsobjekt kann beispielsweise ein menschlicher oder tierischer Patient sein. Eine Magnetresonanzsequenz umfasst üblicherweise mehrere zeitlich und/oder aufeinander folgende Sequenzmodule wie insbesondere HF-Pulse und/oder Gradientenpulse.

Gemäß dem vorgeschlagenen Verfahren werden mehrere Eingangsparameter, insbesondere mittels einer Bereitstellungseinheit, bereitgestellt. Dabei ist jeder der zu messenden Schichten jeweils zumindest ein Eingangsparameter der mehreren Eingangsparameter zugeordnet. Die mehreren Eingangsparameter können beispielsweise in Form eines dreidimensionalen Datensatzes, der etwa Karten (z.B. BO-Karten) für mehrere Schichten repräsentiert, bereitgestellt werden.

Beispielsweise ist jeder Schicht genau ein spezifischer Eingangsparameter desselben Parametertyps zugeordnet. Beispielsweise ist einer ersten Schicht ein erster Eingangsparameter zugeordnet, einer zweiten Schicht ein zweiter Eingangsparameter, etc.

Es können pro Schicht aber auch mehrere Eingangsparameter zuordnet werden. Beispielsweise ist der ersten Schicht ein erster erster Eingangsparameter und ein erster zweiter Eingangsparameter zugeordnet; der zweiten Schicht ist ein zweiter erster Eingangsparameter und ein zweiter zweiter Eingangsparameter zugeordnet etc. Dabei weisen beispielsweise die ersten Eingangsparameter der verschiedenen Schichten (erster erster Eingangsparameter, zweiter erster Eingangsparameter usw.) einen gleichen ersten Parametertyp auf, und die zweiten Eingangsparameter (erster zweiter Eingangsparameter, zweiter zweiter Eingangsparameter usw.) der verschiedenen Schichten weisen einen weiteren gleichen zweiten Parametertyp auf usw. Vorzugsweise unterscheiden sich die verschiedenen Parametertypen. Beispielsweise beziehen sich die Parametertypen auf verschiedene Eigenschaften der Schichten, insbesondere Verteilungen verschiedener Feldtypen wie B0-Feld, B1-Feld etc.

Ferner werden, insbesondere mittels einer Identifizierungseinheit, mehrere Schichtblöcke, insbesondere hinsichtlich einer Ähnlichkeit der Eingangsparameter der einem Schichtblock zugeordneten Schichten, identifiziert. Sofern verschiedene Parametertypen vorliegen, werden die mehreren Schichtblöcke vorzugsweise hinsichtlich einer Ähnlichkeit der Eingangsparameter des gleichen Parametertyps identifiziert.

Dabei ist jedem der mehreren Schichtblöcken zumindest eine Schicht der mehreren zu messenden Schichten zugeordnet, d.h. ein Schichtblock kann eine oder mehrere der zu messenden Schichten umfassen.

Die Eingangsparameter der Schichten desselben Schichtblocks erfüllen dabei zumindest ein, insbesondere vorbestimmtes, Ähnlichkeitskriterium. Insbesondere kann aus mehreren Ähnlichkeitskriterien auch ein kombiniertes Ähnlichkeitskriterium gebildet werden, das die Eingangsparameter der Schichten desselben Schichtblocks erfüllen müssen.

Beispielsweise werden einzelne Schichten eines dreidimensionalen Datensatz von Eingangsparametern nacheinander evaluiert. Ist die gerade betrachtete Schicht hinreichend ähnlich zur davor betrachteten Schicht, können die beiden Schichten in einem Schichtblock zusammengefasst werden. Für die nächste Schicht kann diese wieder mit den Schichten davor verglichen werden. Insbesondere kann dabei der Vergleich zur ersten Schicht des Schichtblocks, der direkt benachbarten Schicht oder einem Mittelwert (pixel- oder voxelweise in Schichtrichtung) der sich bereits im Schichtblock befindlichen Daten erfolgen. Ist die betrachtete Schicht nicht hinreichend ähnlich, muss ein neuer Schichtblock angefangen werden und der vorherige Schichtblock endet mit der davorliegenden Schicht.

Ferner wird, insbesondere mittels einer Ermittlungseinheit, schichtblockweise zumindest ein Puls der Magnetresonanzsequenz zur, insbesondere gemeinsamen und/oder gleichzeitigen und/oder parallelen, Verwendung für alle Schichten des jeweiligen Schichtblocks ermittelt. Vorzugsweise wird pro Schichtblock zumindest ein Puls der Magnetresonanzsequenz zur, insbesondere gemeinsamen und/oder gleichzeitigen und/oder parallelen, Verwendung für alle Schichten des jeweiligen Schichtblocks ermittelt. Beispielsweise können mit einem Puls alle Schichten des jeweiligen Schichtblocks, insbesondere gemeinsamen und/oder gleichzeitigen und/oder parallelen, zur Erzeugung von Magnetresonanzsignalen angeregt werden.

Beispielsweise wird für einen ersten Schichtblock zumindest ein erster Puls ermittelt, für einen zweiten Schichtblock wird zumindest ein zweiter Puls ermittelt usw. Ein solcher Puls kann beispielsweise ein Anregungspuls zur Anregung von Kernspins des Untersuchungsobjekts, die innerhalb der Schichten desselben Schichtblocks liegen, sein.

Der ermittelte zumindest eine Puls der Magnetresonanzsequenz kann insbesondere zumindest ein HF-Puls sein, der mit einer ("1Tx") oder mehreren ("pTx") Sendeantennen bzw. Sendekanälen erzeugt wird.

Die Bereitstellungseinheit, die Identifizierungseinheit und/oder die Ermittlungseinheit umfassen vorzugsweise einen oder mehrere Prozessoren und/oder Speichermodule. Die Bereitstellungseinheit, die Identifizierungseinheit und/oder die Ermittlungseinheit können insbesondere Teil einer Systemsteuereinheit der Magnetresonanzvorrichtung sein.

Vorzugsweise wird der für einen Schichtblock ermittelte Puls während einer Magnetresonanzmessung auf alle Schichten des Schichtblocks, insbesondere gemeinsam und/oder gleichzeitig und/oder parallel, angewendet. Beispielsweise werden alle Schichten des Schichtblocks, insbesondere gemeinsam und/oder gleichzeitig und/oder parallel, angeregt.

Vorzugsweise liegen die mehreren zu messenden Schichten in zueinander parallelen Ebenen. Beispielsweise beträgt die Anzahl der zu messenden Schichten 20 und die Anzahl der identifizierten Schichtblöcke 2; vorteilhafterweise kann in diesem Fall die Anzahl der zu ermittelnden Pulse um den Faktor 20/2 = 10 reduziert werden, so dass auch die benötigte Zeit zur Ermittlung der Pulse, die für die Messung mehrerer Schichten nötig sind, reduziert werden kann. Vorteilhafterweise ist der für einen bestimmten Schichtblock ermittelte zumindest eine Puls geeignet, auf alle Schichten dieses Schichtblocks, insbesondere gemeinsam und/oder gleichzeitig und/oder parallel, angewendet zu werden.

Vorzugsweise umfasst der zumindest eine ermittelte Puls zumindest einen dynamischen Puls, insbesondere zumindest einen pTx-Puls. Beispielsweise wird für jeden der Schichtblöcke ein dynamischer Puls berechnet.

Als dynamischer Puls kann insbesondere ein HF-Puls, insbesondere ein HF-Sendepuls, angesehen werden, dessen Phase und/oder Amplitude sich im zeitlichen Verlauf des Pulses ändert, während mittels einer Gradientenspuleneinheit der Magnetresonanzvorrichtung eine, insbesondere vorbestimmte, Gradiententrajektorie abgetastet wird. Insbesondere erfolgt die Abtastung der Gradiententrajektorie zeitlich mit der Variation von Phase und/oder Amplitude des HF-Pulses.

Es ist auch denkbar, die Gesamtheit aus HF-Puls und Gradiententrajektorie als dynamischen Puls zu betrachten. Dann wäre der HF-Puls ein Teil des dynamischen Pulses.

"pTx" steht hierbei für "paralleles Senden", engl. "parallel transmission". Ein pTx-Puls kann mehrere Teilpulse umfassen, die parallel, insbesondere gleichzeitig, durch jeweils eine Sendeantenne einer Hochfrequenzantenneneinheit der Magnetresonanzvorrichtung gesendet werden. Jeder Sendeantenne kann wiederum ein Sendekanal zugeordnet werden. Dabei können sich die Teilpulse insbesondere in ihrer Form und/oder Amplitude und/oder Phase unterscheiden. Ferner können die Teilpulse eine zeitliche Verzögerung zueinander aufweisen. Beispielsweise setzt sich ein emittierbarer HF-Puls aus mehreren Teilpulsen zusammen, die voneinander abweichen und jeweils durch eine Sendeantenne einer mehrkanaligen Sendeantennenanordnung der Hochfrequenzantenneneinheit gesendet werden können. Vorzugsweise sind zumindest ein Teil der mehreren Teilpulse, insbesondere alle Teilpulse, dynamische Pulse.

Durch einen dynamischen Puls kann vorteilhafterweise das dadurch erzeugte B1-Feld präziser kontrolliert werden; eine solche Kontrolle kann insbesondere bei Anwendungen mit reduziertem Sichtfeld, geformten Sättigungsbändern oder zur Reduktion der spezifischen Absorptionsrate vorteilhaft sein. Insbesondere können mit einem pTx-Puls Magnetfeldinhomogenitäten ausgeglichen werden (beispielsweise im Rahmen eines "HF-Shimming"), das vor allem bei höheren Feldstärken des Hauptmagnetfelds ab 7 Tesla besonders vorteilhaft sein kann.

Bei einem Senden eines dynamischen Pulses, insbesondere eines pTx-Pulses, lässt sich vorteilhafterweise eine vorbestimmte räumliche Verteilung der Anregung als zusätzlicher Freiheitsgrad durch Interferenz der Signale der Mehrzahl an Sendekanälen über eine Mehrzahl an Sendeantennen der Hochfrequenzantenneneinheit erzielen, die beim Bestimmen des dynamischen Pulses beispielsweise durch Variation von Phase und Amplitude eingestellt wird.

Vorzugsweise umfasst das Ermitteln des zumindest eines Pulses der Magnetresonanzsequenz ein Optimieren einer Magnetresonanzanregung.

Beispielsweise wird eine Fettsättigung im Untersuchungsobjekt optimiert, die mittels des zumindest einen Pulses durchgeführt wird. Gemäß einem weiteren Beispiel wird der zumindest eine Puls dahingehend optimiert, dass die Magnetresonanzanregung eine möglichst hohe räumliche Homogenität aufweist.

Beispielsweise wird eine gezielte Magnetresonanzanregung, insbesondere Sättigung, nur eines festgelegten Volumenbereiches (z.B. der Leber) optimiert. Idealerweise werden somit nur Magnetresonanzsignale in diesem festgelegten Volumenbereiche erzeugt, um Einfaltungen aus umgebenden Bereichen zu vermeiden.

Vorteilhafterweise werden die zu messenden Schichten den Schichtblöcken so zugeordnet, dass über das gesamte Schichtvolumen eines Schichtblockes hinweg jeweils eine möglichst gute Optimierung des zumindest einen Pulses möglich ist.

Vorzugsweise umfassen die mehreren Eingangsparameter mehrere, insbesondere schichtspezifische, Karten, insbesondere B0-Karten, B1-Karten, Relaxationszeit-Karten und/oder Protonendichte-Karten. Eine BO-Karte beschreibt insbesondere eine B0-Feldverteilung. Ein B0-Feld bezeichnet insbesondere das statische Hauptmagnetfeld der Magnetresonanzvorrichtung. Eine B1-Karte beschreibt insbesondere eine B1-Feldverteilung. Das B1-Feld bezeichnet insbesondere das durch eine oder mehrere Sendeantennen erzeugte magnetische Wechselfeld der HF-Einstrahlung.

Eine Relaxationszeit-Karte beschreibt insbesondere eine räumliche Verteilung einer Relaxationszeit. Die Relaxationszeit bezeichnet üblicherweise die Zeit eines dynamischen physikalischer Prozesses, bei dem ein System aus einem Zustand des Ungleichgewichts, insbesondere durch Anregung von Kernspins, in sein Gleichgewicht zurückkehrt. Beispielsweise bezeichnet die Relaxationszeit eine gewebespezifische Zeitkonstante, welche die Rückkehr der Längsmagnetisierung in den Gleichgewichtszustand beschreibt (Längsrelaxationszeit bzw. T1-Konstante). Beispielsweise bezeichnet die Relaxationszeit eine gewebespezifische Zeitkonstante, die den Zerfall der Quermagnetisierung im ideal homogenen Magnetfeld beschreibt (Querrelaxationszeit bzw. T1-Konstante).

Eine Protonendichte-Karte beschreibt insbesondere eine räumliche Verteilung einer Protonendichte. Die Protonendichte ist insbesondere die Dichte an Protonen im Untersuchungsobjekt, die durch eine HF-Puls angeregt werden können.

Eine solche Karte beschreibt insbesondere eine räumliche Verteilung einer Eigenschaft der Schicht. Eine solche Karte weist insbesondere eine Anzahl an Pixeln und/oder Voxeln auf, wobei jedem Pixel und/oder Voxel ein Wert zugeordnet ist.

Unter einem Pixel kann insbesondere ein kleinstes Bildelement einer Bildmatrix, insbesondere einer Karte, verstanden werden. Unter einem Voxel kann insbesondere ein Volumenelement eines Untersuchungsobjekts verstanden werden, das insbesondere einem Pixel in einer Bildmatrix, insbesondere in einer Karte, zugeordnet werden kann.

Vorzugsweise umfasst das Identifizieren der mehreren Schichtblöcke einen, insbesondere pixelweisen und/oder voxelweisen, Vergleich der mehreren, insbesondere schichtspezifischen, Karten, als Eingangsparameter.

Beispielsweise umfasst der Vergleich der mehreren Karten eine pixelweise und/oder voxelweise Differenzberechnung der Werte der Karten. Insbesondere wird ermittelt, wie stark die Werte der jeweiligen Pixel und/oder Voxel voneinander abweichen. Vorteilhafterweise werden nur diejenigen Schichten zu einem Schichtblock zusammengefasst, deren pixelweise und/oder voxelweise Differenz ausreichend gering ist.

Beispielsweise umfasst der Vergleich der mehreren Karten ein Ermitteln einer Anzahl von Pixeln und/oder Voxeln der mehreren Karten, denen Werte zugeordnet sind, die einen vorgegebenen Schwellwert überschreiten. Beispielsweise werden nur diejenigen Schichten zu einem Schichtblock zusammengefasst, wenn die Anzahl von Pixeln und/oder Voxeln der Schichten, die einen vorgegebenen Schwellwert nicht überschreiten, ausreichend gering ist.

Beispielsweise umfasst der Vergleich der mehreren Karten einen Vergleich von Mittelwerten von verschiedenen Bereichen der mehreren Schichten über die Schichten hinweg.

Das Identifizieren der mehreren Schichtblöcke kann insbesondere folgende Schritte umfassen:

a) Es wird eine voxelweise Abweichung, insbesondere Differenz, der Eingangsparameter zweier Schichten berechnet. Beispielsweise Voxel für Voxel eine Abweichung zweier BO-Karten berechnet.

b) Es werden eine Anzahl an in a) berechneten Abweichungen bestimmt, deren Werte einen vorbestimmten Schwellwert überschreiten. Beispielsweise werden alle Abweichungen zweier BO-Karten gezählt, deren Werte über dem vorbestimmten Schwellwert, z.B. 30 Hz, liegen. Der vorbestimmte Schwellwert kann beispielsweise empirisch bestimmt werden.

c) Es wird eine gemittelte Abweichung der Eingangsparameter der zwei Schichten ermittelt. Dazu werden vorzugsweise die in a) berechneten voxelweisen Abweichungen gemittelt. Beispielsweise wird eine Summe der Abweichungsquadrate (Varianz) oder deren Wurzel (Standardabweichung) ermittelt. Beispielsweise erhält man dadurch eine Varianz oder Standardabweichung der zwei betrachteten BO-Karten.

d) Es wird festgestellt, ob die Eingangsparameter der zwei Schichten zwei Ähnlichkeitskriterien erfüllen: Falls die in b) ermittelte Anzahl einen vorbestimmten Anteil an der Anzahl aller Voxel überschreitet (z.B. 30%, erstes Ähnlichkeitskriterium) oder die in c) ermittelte gemittelte Abweichung, insbesondere Standardabweichung, einen vorbestimmten Schwellwert überschreitet (z.B. 20 Hz, zweites Ähnlichkeitskriterium), sind die Eingangsparameter der zwei Schichten nicht hinreichend ähnlich. In diesem Fall würden die beiden Schichten nicht demselben Schichtblock zugeordnet werden. Falls die Eingangsparameter der zwei Schichten diese zwei Ähnlichkeitskriterien hingegen erfüllen, werden die zwei Schichten demselben Schichtblock zugeordnet. Auch die in d) verwendeten Schwellwerte, insbesondere Anteile, können beispielsweise empirisch ermittelt werden.

Der Vergleich der Schichten kann insbesondere relativ zu einer festen Schicht, insbesondere zur ersten Schicht, eines Schichtblockes stattfinden. Es ist aber auch denkbar, dass der Vergleich auch die anderen Schichten eines Schichtblockes mit einbezieht.

Vorzugsweise berücksichtigt das Identifizieren der mehreren Schichtblöcke eine Anatomie eines zu messenden Untersuchungsobjekts. Beispielsweise umfasst das Identifizieren der mehreren Schichtblöcke eine schichtweise Ermittlung einer Größe eines anatomischen Bereichs innerhalb der Schicht. Die Größe des anatomischen Bereichs innerhalb der Schicht kann insbesondere aus Werten der Pixel und/oder Voxel abgeleitet werden, die einen vorgegebenen Schwellwert überschreiten. Pixel und/oder Voxel außerhalb des anatomischen Bereichs weisen üblicherweise kein Signal auf, d.h. sie überschreiten den vorgegeben Schwellwert nicht.

So kann beispielsweise ein Halsbereich (aufweisend relativ wenige einen Schwellwert überschreitende Pixel und/oder Voxel) von einem Kopfbereich (aufweisend relativ viele den Schwellwert überschreitende Pixel und/oder Voxel) eines Patienten unterschieden werden; die im Halsbereich liegenden Schichten können beispielsweise einem ersten Schichtblock zugeordnet werden, und die im Kopfbereich liegenden Schichten können beispielsweise einem zweiten Schichtblock zugeordnet werden.

Vorzugsweise wird eine minimale und/oder maximale Anzahl von Schichtblöcken vorgegeben, die bei dem Identifizieren der mehrerer Schichtblöcke berücksichtigt wird. Beispielsweise wird eine maximale Anzahl von Schichtblöcken vorgegeben, um sicherzustellen, dass die Ermittlung des zumindest einen Pulses eine gewisse Zeitdauer nicht übersteigt. Beispielsweise wird eine minimale Anzahl von Schichtblöcken vorgegeben, um sicherzustellen, dass die Ermittlung des zumindest einen Pulses hinreichend schichtspezifisch erfolgen kann.

Vorzugsweise wird zumindest ein Referenzparameter anhand der Eingangsparameter der Schichten desselben Schichtblocks ermittelt, und anhand des zumindest einen Referenzparameters wird dann der zumindest eine Puls der Magnetresonanzsequenz ermittelt.

Vorteilhafterweise erfolgt die Optimierung des zumindest einen Pulses auf Basis des Referenzparameters. Insbesondere werden statt der mehreren Eingangsparameter (jeweils einer pro Schicht) nur noch die Referenzparameter (jeweils einer pro Schichtblock) zur Ermittlung des zumindest einen Pulses verwendet. Vorteilhafterweise ist der Referenzparameter geeignet, eine bestimmte Eigenschaft aller Schichten desselben Schichtblocks hinreichend genau zu repräsentieren. Insbesondere weist der Referenzparameter zu den Eingangsparametern aller Schichten desselben Schichtblocks eine hinreichende Ähnlichkeit auf. Vorteilhafterweise ist der auf dieser Basis ermittelte zumindest eine Puls zur Anwendung auf alle Schichten desselben Schichtblocks hinreichend gut geeignet.

Beispielsweise umfasst das Ermitteln des Referenzparameters ein Bestimmen einer, insbesondere räumlich, mittleren Schicht der Schichten eines Schichtblocks, wobei der Eingangsparameter der, insbesondere räumlich, mittleren Schicht als Referenzparameter verwendet wird. Sollte ein Schichtblock eine gerade Anzahl an Schichten aufweisen, kann beispielsweise eine der beiden mittleren Schichten ausgewählt werden. Vorteilhafterweise erfolgt die Ermittlung der mittleren Schicht bzw. deren Eingangsparameter besonders schnell.

Alternativ kann auch beispielsweise aus Eingangsparametern der beiden mittleren Schichten ein gemittelter und/oder interpolierter Eingangsparameter ermittelt werden, der dann als Referenzparameter verwendet wird. Vorteilhafterweise kann durch Mittelung und/oder Interpolation ein besonders genauer Referenzparameter gewonnen werden.

Beispielsweise umfasst das Ermitteln des zumindest einen Referenzparameters ein Bestimmen einer Schicht des Schichtblocks, dessen Eingangsparameter eine größte Ähnlichkeit zu den Eingangsparametern der anderen Schichten des Schichtblocks aufweist, wobei der Eingangsparameter der bestimmten Schicht als Referenzparameter verwendet wird. Die bestimmte Schicht muss nicht notwendigerweise die mittlere Schicht des Schichtblocks sein.

Insbesondere umfasst das Ermitteln des zumindest einen Referenzparameters eine Mittelung der Eingangsparameter der Schichten des Schichtblocks. Beispielsweise können die Eingangsparameter nur eines Teils der Schichten gemittelt werden, etwa die in der Mitte des Schichtblocks liegenden. Es können auch die Eingangsparameter aller Schichten des Schichtblocks gemittelt werden.

Ferner wird eine Magnetresonanzvorrichtung vorgeschlagen, die ausgebildet ist, ein vorab beschriebenes Verfahren auszuführen. Die Vorteile der vorgeschlagenen Magnetresonanzvorrichtung entsprechen im Wesentlichen den Vorteilen des vorgeschlagenen Verfahrens zur Ermittlung zumindest eines Pulses einer Magnetresonanzsequenz zur Messung mehrerer Schichten, welche vorab im Detail ausgeführt sind. Hierbei erwähnte Merkmale, Vorteile oder alternative Ausführungsformen können ebenso auch auf die vorgeschlagene Magnetresonanzvorrichtung übertragen werden und umgekehrt.

Die Magnetresonanzvorrichtung kann zur Ausführung des Verfahrens insbesondere eine Bereitstellungseinheit, die Identifizierungseinheit und/oder die Ermittlungseinheit umfassen. Diese Einheiten können insbesondere Teile einer Systemsteuereinheit der Magnetresonanzvorrichtung sein. Die Magnetresonanzvorrichtung umfasst vorteilhafterweise eine Hochfrequenzantenneneinheit und/oder Gradientenspuleneinheit zur Erzeugung des ermittelten zumindest einen Pulses bei Anwendung der Magnetresonanzsequenz.

Ferner wird ein Computerprogrammprodukt vorgeschlagen, das ein Programm umfasst und direkt in einen Speicher einer programmierbaren Systemsteuereinheit einer Magnetresonanzvorrichtung ladbar ist und Programmmittel, z.B. Bibliotheken und Hilfsfunktionen, aufweist, um ein vorgeschlagenes Verfahren zur Ermittlung zumindest eines Pulses einer Magnetresonanzsequenz zur Messung mehrerer Schichten auszuführen, wenn das Computerprogrammprodukt in der Systemsteuereinheit der Magnetresonanzvorrichtung ausgeführt wird. Das Computerprogrammprodukt kann dabei eine Software mit einen Quellcode, der noch kompiliert und gebunden oder der nur interpretiert werden muss, oder einen ausführbaren Softwarecode umfassen, der zur Ausführung nur noch in die Systemsteuereinheit zu laden ist.

Durch das Computerprogrammprodukt kann das vorgeschlagene Verfahren vorteilhafterweise schnell, identisch wiederholbar und robust ausgeführt werden. Das Computerprogrammprodukt ist vorzugsweise so konfiguriert, dass es mittels der Systemsteuereinheit die vorgeschlagenen Verfahrensschritte ausführen kann. Die Systemsteuereinheit weist dabei jeweils die Voraussetzungen wie beispielsweise einen entsprechenden Arbeitsspeicher, eine entsprechende Grafikkarte oder eine entsprechende Logikeinheit auf, so dass die jeweiligen Verfahrensschritte effizient ausgeführt werden können.

Das Computerprogrammprodukt ist beispielsweise auf einem computerlesbaren Medium gespeichert oder auf einem Netzwerk oder Server hinterlegt, von wo es in den Prozessor einer lokalen Systemsteuereinheit geladen werden kann, der mit der Magnetresonanzvorrichtung direkt verbunden oder als Teil der Magnetresonanzvorrichtung ausgebildet sein kann. Weiterhin können Steuerinformationen des Computerprogrammprodukts auf einem elektronisch lesbaren Datenträger gespeichert sein. Die Steuerinformationen des elektronisch lesbaren Datenträgers können derart ausgestaltet sein, dass sie bei Verwendung des Datenträgers in einer Systemsteuereinheit einer Magnetresonanzvorrichtung ein vorgeschlagenes Verfahren durchführen.

Weitere Vorteile, Merkmale und Einzelheiten der Erfindung ergeben sich aus den im Folgenden beschriebenen Ausführungsbeispielen sowie anhand der Zeichnungen. Einander entsprechende Teile sind in allen Figuren mit den gleichen Bezugszeichen versehen.

Es zeigen:

Fig. 1 eine Magnetresonanzvorrichtung in einer schematischen Darstellung,

Fig. 2 ein Ablaufdiagramm eines Verfahrens, bei dem zumindest ein Puls einer Magnetresonanzsequenz zur Messung mehrerer Schichten ermittelt wird,

Fig. 3 ein Diagramm, das ein Identifizieren mehrerer Schichtblöcke illustriert.

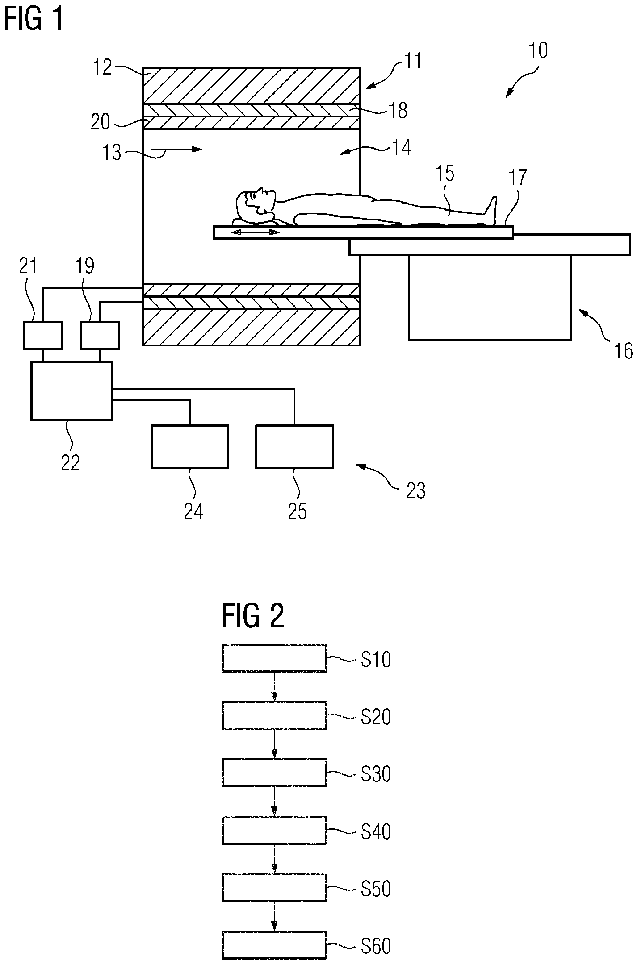

In Fig. 1 ist eine Magnetresonanzvorrichtung 10 schematisch dargestellt. Die Magnetresonanzvorrichtung 10 umfasst eine Magneteinheit 11, die einen Hauptmagneten 12 zu einem Erzeugen eines starken und insbesondere zeitlich konstanten Hauptmagnetfelds 13 aufweist. Zudem umfasst die Magnetresonanzvorrichtung 10 einen Patientenaufnahmebereich 14 zu einer Aufnahme eines Untersuchungsobjekts, insbesondere eines Patienten 15. Der Patientenaufnahmebereich 14 im vorliegenden Ausführungsbeispiel ist zylinderförmig ausgebildet und in einer Umfangsrichtung von der Magneteinheit 11 zylinderförmig umgeben. Grundsätzlich ist jedoch eine davon abweichende Ausbildung des Patientenaufnahmebereichs 14 jederzeit denkbar. Der Patient 15 kann mittels einer Patientenlagerungsvorrichtung 16 der Magnetresonanzvorrichtung 10 in den Patientenaufnahmebereich 14 geschoben werden. Die Patientenlagerungsvorrichtung 16 weist hierzu einen innerhalb des Patientenaufnahmebereichs 14 bewegbar ausgestalteten Patiententisch 17 auf.

Die Magneteinheit 11 weist weiterhin eine Gradientenspuleneinheit 18 zu einer Erzeugung von Magnetfeldgradienten auf, die für eine Ortskodierung während einer Bildgebung verwendet werden. Die Gradientenspuleneinheit 18 wird mittels einer Gradientensteuereinheit 19 der Magnetresonanzvorrichtung 10 gesteuert. Die Magneteinheit 11 umfasst weiterhin eine Hochfrequenzantenneneinheit 20, welche im vorliegenden Ausführungsbeispiel als fest in die Magnetresonanzvorrichtung 10 integrierte Körperspule ausgebildet ist. Hochfrequenzantenneneinheit 20 kann aber auch eine oder mehrere Lokalspulen umfassen, die am Patienten 15 angeordnet sind (nicht dargestellt). Eine Lokalspule kann insbesondere eine oder mehrere Sendeantennen umfassen.

Die Hochfrequenzantenneneinheit 20 wird von einer Hochfrequenzantennensteuereinheit 21 der Magnetresonanzvorrichtung 10 gesteuert und strahlt hochfrequenten Pulse in einen Untersuchungsraum ein, der im Wesentlichen von einem Patientenaufnahmebereich 14 der Magnetresonanzvorrichtung 10 gebildet ist. Dadurch stellt sich dem von dem Hauptmagneten 12 erzeugten Hauptmagnetfeld 13 eine Anregung von Atomkernen ein. Vorzugsweise umfasst die Hochfrequenzantenneneinheit 20 mehrere Spulenantennen, so dass die Hochfrequenzantenneneinheit 20 ausgebildet ist, pTx-Pulse zu erzeugen. Durch Relaxation der angeregten Atomkerne werden Magnetresonanzsignale erzeugt. Die Hochfrequenzantenneneinheit 20 ist zum Empfang der Magnetresonanzsignale ausgebildet.

Zu einer Steuerung des Hauptmagneten 12, der Gradientensteuereinheit 19 und zur Steuerung der Hochfrequenzantennensteuereinheit 21 weist die Magnetresonanzvorrichtung 10 eine Systemsteuereinheit 22 auf. Die Systemsteuereinheit 22 steuert zentral die Magnetresonanzvorrichtung 10, wie beispielsweise das Durchführen einer vorbestimmten bildgebenden Magnetresonanzsequenz. Beispielsweise werden gemäß der Magnetresonanzsequenz mehrere Schichten des Patienten 15 gemessen, wobei hierfür dabei zumindest ein Puls verwendet wird, der gemäß einem hier vorgeschlagenen Verfahren ermittelt wird.

Zudem umfasst die Systemsteuereinheit 22 eine nicht näher dargestellte Auswerteeinheit zu einer Auswertung der Magnetresonanzsignale, die während der Magnetresonanzuntersuchung erfasst werden. Des Weiteren umfasst die Magnetresonanzvorrichtung 10 eine Benutzerschnittstelle 23, die mit der Systemsteuereinheit 22 verbunden ist. Steuerinformationen wie beispielsweise Bildgebungsparameter, sowie rekonstruierte Magnetresonanzabbildungen können auf einer Anzeigeeinheit 24, beispielsweise auf zumindest einem Monitor, der Benutzerschnittstelle 23 für ein medizinisches Bedienpersonal angezeigt werden. Weiterhin weist die Benutzerschnittstelle 23 eine Eingabeeinheit 25 auf, mittels der Informationen und/oder Parameter während eines Messvorgangs von dem medizinischen Bedienpersonal eingegeben werden können.

In Fig. 2 ist ein mögliches Verfahren zur Ermittlung zumindest eines Pulses einer Magnetresonanzsequenz zur Messung mehrerer Schichten schematisch dargestellt.

In S10 werden mehrere Eingangsparameter erfasst, insbesondere gemessen. Beispielsweise wird mit der Magnetresonanzvorrichtung 10 für jede zu messender Schicht jeweils eine Karte, beispielsweise eine BO-Karte, aufgenommen. Die BO-Karte beschreibt die Verteilung des statischen Magnetfeldes, insbesondere des Hauptmagnetfeldes 13, in der jeweiligen Schicht. Verschiedene Methoden zur Erfassung von BO-Karten sind hinlänglich bekannt.

Andere mögliche Eingangsparameter wären beispielsweise B1-Karten, Relaxationszeit-Karten und/oder Protonendichte-Karten.

In S20 werden die mehreren Eingangsparameter bereitgestellt, wobei jeder der zu messenden Schichten jeweils zumindest ein Eingangsparameter der mehreren Eingangsparameter zugeordnet ist. Insbesondere werden die in S10 gemessenen BO-Karten als Eingangsparameter bereitgestellt. Da für jede zu messende Schicht jeweils eine BO-Karte aufgenommen wurde, ist auch jeder Schicht jeweils zumindest eine BO-Karte zugeordnet.

In S30 werden mehrere Schichtblöcke identifiziert, wobei jedem der mehreren Schichtblöcke zumindest eine Schicht der mehreren zu messenden Schichten zugeordnet ist. Dabei erfüllen die Eingangsparameter der Schichten desselben Schichtblocks zumindest ein Ähnlichkeitskriterium.

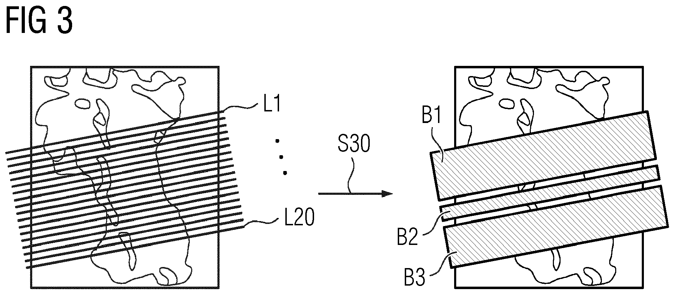

In Fig. 3 wird das Identifizieren der Schichtblöcke grafisch dargestellt. Die senkrecht zur Zeichenebene verlaufenden Schichten L1 bis L20 sollen gemessen werden. Die zu messenden Schichten L1 bis L20 können beispielsweise im Rahmen einer Messvorbereitung festgelegt werden, beispielsweise durch das Bedienpersonal mittels der Benutzerschnittstelle 23.

Das gesamte Messvolumen, in dem die zu messenden Schichten liegen, erstreckt sich über einen Teil des Kopfes und den Hals des Patienten 15. In S20 werden die Schichten L1,...,L20 in drei Schichtblöcke B1, B2, B3 eingeteilt, z.B. die Schichten L1,...,L8 in Schichtblock B1, die Schichten L9,...,L12 in Schichtblock B2 und die Schichten L13,...,L20 in Schichtblock B3.

Die Einteilung erfolgt dabei mit der Bedingung, dass sich die BO-Karten der Schichten innerhalb desselben Schichtblocks hinreichend ähnlich sein müssen, d.h. die BO-Karten erfüllen zumindest ein Ähnlichkeitskriterium. Je nach Grad der Ähnlichkeit der BO-Karten kann sich die Notwendigkeit von mehr oder weniger Schichtblöcken ergeben. Es ist aber auch denkbar, die Anzahl der Schichtblöcke nach oben zu begrenzen und das zumindest eine Ähnlichkeitskriterium in Abhängigkeit dieser Vorgabe anzupassen, d.h. gegebenenfalls wird auch eine größere Unähnlichkeit der Eingangsparameter der Schichten desselben Schichtblocks akzeptiert, um die Vorgabe der maximalen Anzahl an Schichtblöcken einzuhalten.

Ein solches Ähnlichkeitskriterium kann beispielsweise eine darin bestehen, dass sich Werte der jeweiligen Pixel und/oder Voxel der Karten, insbesondere der BO-Karten, der Schichten desselben Schichtblocks nur um einen vorbestimmten Wert unterscheiden dürfen. Es ist auch denkbar, dass man vor einem solchen Vergleich, die Rohdaten der in S20 bereitgestellten Karten, insbesondere BO-Karten, vorbearbeitet, etwa indem Ausreißer in den Messdaten glättet oder entfernt.

Es ist auch denkbar, dass man eine Varianz der Werte der B0-Karten miteinander vergleicht, um die Ähnlichkeit der B0-Karten zu bewerten. Auch eine Anzahl an Pixel und/oder Voxel der Karten, die innerhalb eines bestimmten Wertebereichs liegen sollen, kann zur Definition des zu erfüllenden Ähnlichkeitskriterium herangezogen werden.

Insbesondere kann das Identifizieren der mehreren Schichtblöcke einen, insbesondere pixelweisen und/oder voxelweisen, Vergleich der mehreren Karten, als Eingangsparameter umfassen. Mit diesem Vergleich kann festgestellt werden, ob das zumindest eine Ähnlichkeitskriterium verfüllt ist. Ergibt der Vergleich beispielsweise, dass sich die Eingangsparameter zweier Schichten zu stark unterscheiden, dann werden diese Schichten verschiedenen Schichtblöcken zugeordnet.

Die hinreichende Ähnlichkeit der Eingangsparameter macht sich dabei vorzugsweise zum Zwecke der Anregungsoptimierung fest. Beispielsweise zielt dies auf eine verbesserte Fettsättigung ab, wofür BO-Karten als Eingangsparameter hinreichend ähnlich sein müssen. Beim Vergleich der Schichten kann dabei beispielsweise auf Kennzahlen geachtet werden, wie eine Anzahl der Pixel, die mehr als ein vorgegebener Schwellwert von Null abweichen, ein pixelweiser Vergleich über die Schichten bis ein Schwellwert überschritten wird, Mittelwerte in verschiedenen Bereichen verglichen über die Schichten, Standardabweichungen, etc.

Weitere Eingangsparameter, neben der oben genannten B0-Karten, könnten beispielsweise B1-Karten, Relaxationszeiten, Protonendichten sein.

Insbesondere kann das Identifizieren der mehreren Schichtblöcke eine Anatomie des Patienten 15 berücksichtigen. Insbesondere werden die Schichten, die im selben anatomischen Abschnitt des Patienten liegen, demselben Schichtblock zugeordnet. Beispielsweise wird berücksichtigt, dass die Schichten L9,...,L12 im Halsbereich des Patienten 15 liegen, welche dann dem Schichtbloch B2 zugeordnet werden.

Beispielsweise kann derselbe anatomische Abschnitt durch eine Anzahl und/oder Verteilung der Pixel und/oder Voxel der B0-Karte, deren Werte in einem bestimmten Bereich liegen, ermittelt werden. Eine BO-Karte im Halsbereich umfasst üblicherweise weniger Pixel und/oder Voxel, deren Werte über ein Rauschenniveau hinausgehen, als eine BO-Karte im Kopfbereich.

In S40 wird für jeden Schichtblock B1,B2,B3 zumindest ein Referenzparameter anhand der Eingangsparameter der Schichten derselben Schichtblocks ermittelt.

Beispielsweise wird als Referenzparameter der Eingangsparameter eines Schichtblocks bestimmt, der eine größte Ähnlichkeit zu den Eingangsparametern des Schichtblocks aufweist.

Um die Ähnlichkeit der Eingangsparameter festzustellen, wird vorteilhafterweise eine Ähnlichkeitsmetrik angewendet. Handelt es sich bei Eingangsparametern um Karten, z.B. B0-Karten, kann beispielsweise eine Differenz der Werte der Pixel und/oder Voxel zweier Karten berechnet und deren Beträge aufsummiert werden:

$$M_{a,b} = \sum_{x,y} \left| a_{x,y} - b_{x,y} \right|$$

Dabei sind $M_{a,b}$ ein Maß für die Ähnlichkeit der Karten der Schichten a und b desselben Schichtblocks; $a_{x,y}$ ist der Wert des Pixels mit den Koordinate x,y der Karte der Schicht a; $b_{x,y}$ ist der Wert des Pixels mit den Koordinate x,y der Karte der Schicht b. Statt der Summe der Beträge kann beispielsweise auch die Wurzel der Summe der Quadrate der Differenzen zur Bestimmung des Ähnlichkeitsmaßes verwendet werden.

Vorzugsweise wird für jede mögliche Schichtkombination eines Schichtblocks dieses Maß berechnet. Für jede Schicht eines Schichtblocks wird der maximale Wert $\max(M_{a,b})$ der möglichen Schichtenkombinationen ermittelt, an der die Schicht beteiligt ist; die Karte derjenigen Schicht, deren maximaler Wert $\max(M_{a,b})$ am kleinsten ist, wird als Referenzparameter gewählt.

Es sind jedoch eine Reihe anderer Ähnlichkeitsmetriken denkbar, indem beispielsweise statt des Betrags das Quadrat der Differenz der Werte der Pixel und/oder Voxel zweier Karten berechnet wird etc.

Eine andere Möglichkeit zur Bestimmung einer Schicht, deren Eingangsparameter als Referenzparameter verwendet werden soll, kann darin bestehen, eine mittlere Schicht des Schichtblocks zu bestimmen, d.h. der zumindest eine Eingangsparameter der mittleren Schicht des Schichtblocks wird als der zumindest eine Referenzparameter verwendet.

Ferner ist denkbar, die Eingangsparameter der Schichten eines Schichtblocks zu mitteln und das Ergebnis dieser Mittelung als Referenzparameter verwenden.

In S50 von Fig. 2 wird für jeden Schichtblock zumindest ein Puls der Magnetresonanzsequenz ermittelt, der vorgesehen ist, für und/oder auf alle Schichten des jeweiligen Schichtblocks anzuwenden. Die Ermittlung des zumindest einen Pulses erfolgt vorzugsweise anhand der (hinreichend ähnlichen) Eingangsparameter der Schichten desselben Schichtblocks. Vorzugsweise erfolgt die Ermittlung des zumindest einen Pulses anhand des in S40 ermittelten Referenzparameters, der aus den Eingangsparametern der Schichten des Schichtblocks ermittelt wurde. Vorzugsweise dient die Schicht mit der größten Ähnlichkeit zu den anderen Schichten eines Schichtblockes als Berechnungsgrundlage. Durch diese wohldefinierte Selektion der Grundlage (z.B. die BO-Karte) zur Berechnung des zugehörigen, insbesondere dynamischen, Pulses kann ein möglichst passender Puls für alle Schichten desselben Schichtblockes bestimmt werden.

Je nach Typ der Magnetresonanzsequenz kann der zumindest eine Puls mehr oder weniger Pulse umfassen, die im Verlauf der Magnetresonanzsequenz zu applizieren sind.

Bezogen auf das in Fig. 3 dargestellte Beispiel wird also beispielsweise anhand der BO-Karten als Eingangsparameter der Schichten L1,...,L8 des Schichtblocks B1 zumindest ein erster Puls ermittelt; anhand der BO-Karten als Eingangsparameter der Schichten L9,...,L12 des Schichtblocks B2 wird zumindest ein zweiter Puls ermittelt; anhand der BO-Karten als Eingangsparameter der Schichten L13,...,L20 des Schichtblocks B3 wird zumindest ein zweiter Puls ermittelt.

Die ermittelten Pulse können insbesondere dynamische Pulse sein. Das Ermitteln des zumindest eines Pulses, insbesondere dynamischen Pulses, in S50 umfasst vorzugsweise ein Optimieren einer Magnetresonanzanregung. Vorteilhafterweise kann mit solchen dynamischen Pulsen eine gezieltere MR-Anregung von Kernspins im Patienten 15 durchgeführt werden.

In S60 wird dann gemäß einer Magnetresonanzsequenz, die die in S50 ermittelten Pulse umfassen, mit der Magnetresonanzvorrichtung 10 eine Messung durchgeführt. Bei dieser Messung werden Magnetresonanzsignale empfangen, aus denen eine oder mehrere Magnetresonanzabbildungen rekonstruiert werden können.

Mit dem in Fig. 2 dargestellten Verfahren kann vorteilhafterweise die Rechenzeit zur Berechnung von, insbesondere dynamischen, Pulsen bei Aufnahmen mit mehreren Schichten reduziert werden.

Für eine in Fig. 3 beispielhaft dargestellte transversale Messung im Nackenbereich des Patienten 15 mit zwanzig Schichten würden nach dem Stand der Technik zwanzig Pulse berechnet werden. Bei einer typischen Rechenzeit von 5 Sekunden pro Puls würde dies 100 Sekunden dauern. Vorzugsweise werden die Schichten miteinander verglichen und beispielhaft festgestellt, dass sich die zwanzig Schichten in drei Schichtblöcke unterteilen lassen umfassend die Schichten L1,...,8, L9,...,L12 und L13,...,L20. In den einzelnen Schichtblöcken ist beispielsweise die BO-Karte hinreichend ähnlich. Auf diese Weise kann die Rechenzeit von 100 Sekunden auf fünfzehn Sekunden reduziert, was lediglich in etwa der Dauer eines Shimvorganges entspricht.

Das vorgeschlagene Verfahren ist vorzugsweise durch einen Vergleich von Schichten auf hinreichende Ähnlichkeit, dem Zusammenfassen von hinreichend ähnlichen Schichten in Schichtblöcke und dem Berechnen des Pulses eines Schichtblockes anhand von geeigneter Selektion der Eingangsparametern aller zugehörigen Schichten (z.B. durch pixelweises Mitteln der Werte innerhalb eines Schichtblockes) gekennzeichnet.

Es wird abschließend noch einmal darauf hingewiesen, dass es sich bei den vorhergehend detailliert beschriebenen Verfahren sowie bei der dargestellten lediglich um Ausführungsbeispiele handelt, welche vom Fachmann in verschiedenster Weise modifiziert werden können, ohne den Bereich der Erfindung zu verlassen. Weiterhin schließt die Verwendung der unbestimmten Artikel "ein" bzw. "eine" nicht aus, dass die betreffenden Merkmale auch mehrfach vorhanden sein können. Ebenso schließt der Begriff "Einheit" nicht aus, dass die betreffenden Komponenten aus mehreren zusammenwirkenden Teil-Komponenten bestehen, die gegebenenfalls auch räumlich verteilt sein können.

**Patentansprüche**

1. Verfahren zur Ermittlung zumindest eines Pulses einer Magnetresonanzsequenz zur Messung mehrerer Schichten, wobei das Verfahren umfasst:

   - Bereitstellen mehrerer Eingangsparameter, wobei jeder der zu messenden Schichten jeweils zumindest ein Eingangsparameter der mehreren Eingangsparameter zugeordnet ist,
   - Identifizieren mehrerer Schichtblöcke,

      wobei jedem der mehreren Schichtblöcke zumindest eine Schicht der mehreren zu messenden Schichten zugeordnet ist, wobei die Eingangsparameter der Schichten desselben Schichtblocks zumindest ein Ähnlichkeitskriterium erfüllen,

   - schichtblockweises Ermitteln zumindest eines Pulses der Magnetresonanzsequenz zur Verwendung für alle Schichten des jeweiligen Schichtblocks.

2. Verfahren nach Anspruch 1, wobei der zumindest eine Puls zumindest einen dynamischen Puls umfasst.

3. Verfahren nach einem der vorangehenden Ansprüche, wobei das Ermitteln des zumindest eines Pulses der Magnetresonanzsequenz ein Optimieren einer Magnetresonanzanregung umfasst.

4. Verfahren nach einem der vorangehenden Ansprüche, wobei die mehreren Eingangsparameter mehrere Karten, insbesondere BO-Karten, B1-Karten, Relaxationszeit-Karten und/oder Protonendichte-Karten, umfasst.

5. Verfahren nach einem der vorangehenden Ansprüche, wobei das Identifizieren der mehreren Schichtblöcke einen, insbesondere pixelweisen und/oder voxelweisen, Vergleich mehreren Karten, als Eingangsparameter umfasst.

6. Verfahren nach Anspruch 5, wobei der Vergleich der mehreren Karten

- ein Ermitteln einer Anzahl von Pixeln und/oder Voxeln der mehreren Magnetfeldkarten umfasst, deren Werte einen vorgegebenen Schwellwert überschreiten, und/oder

- eine pixelweise und/oder voxelweise Differenzberechnung der Werte der Karten umfasst und/oder

- einen Vergleich von Mittelwerten von verschiedenen Bereichen der mehreren Schichten über die Schichten hinweg umfasst.

7. Verfahren nach einem der vorangehenden Ansprüche,
wobei das Identifizieren der mehreren Schichtblöcke eine Anatomie eines zu messenden Untersuchungsobjekts berücksichtigt.

8. Verfahren nach einem der vorangehenden Ansprüche,
wobei eine minimale und/oder maximale Anzahl von Schichtblöcken vorgegeben wird, die bei dem Identifizieren der mehrerer Schichtblöcke berücksichtigt wird.

9. Verfahren nach einem der vorangehenden Ansprüche,
wobei das Ermitteln des zumindest eines Pulses der Magnetresonanzsequenz umfasst:
Ermitteln zumindest eines Referenzparameters anhand der Eingangsparameter der Schichten derselben Schichtblocks und Ermitteln des zumindest eines Pulses der Magnetresonanzsequenz anhand des zumindest einen Referenzparameters.

10. Verfahren nach Anspruch 9,
wobei das Ermitteln des zumindest einen Referenzparameters ein Bestimmen einer mittleren Schicht der Schichten einer Schichtgruppe umfasst, wobei der zumindest eine Eingangsparameter der mittleren Schicht als der zumindest eine Referenzparameter verwendet wird.

11. Verfahren nach einem der Ansprüche 9 oder 10,
wobei das Ermitteln des Referenzparameters ein Bestimmen einer Schicht der Schichtgruppe umfasst, dessen Eingangsparameter eine größte Ähnlichkeit zu den Eingangsparametern der anderen Schichten des Schichtblocks aufweist, wobei der Eingangsparameter der bestimmten Schicht als Referenzparameter verwendet wird.

12. Verfahren nach einem der Ansprüche 9 bis 11,
wobei das Ermitteln des Referenzparameters eine Mittelung der Eingangsparameter der Schichten des Schichtblocks umfasst.

13. Magnetresonanzvorrichtung, die ausgebildet ist, ein Verfahren nach einem der vorangehenden Ansprüche auszuführen.

14. Computerprogrammprodukt, welches ein Programm umfasst und direkt in einen Speicher einer programmierbaren Systemsteuereinheit einer Magnetresonanzvorrichtung ladbar ist, mit Programmmitteln, um ein Verfahren nach einem der Ansprüche 1 bis 12 auszuführen, wenn das Programm in der Systemsteuereinheit der Magnetresonanzvorrichtung ausgeführt wird.

# FIG 1

# FIG 2

# FIG 3

L1

⋮

L20

S30

B1

B2

B3

Europäisches
Patentamt

European
Patent Office

Office européen
des brevets

## EUROPÄISCHER RECHERCHENBERICHT

**Nummer der Anmeldung**

EP 23 18 1787

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2013 205785 A1 (BECK THOMAS [DE] ET AL) 2. Oktober 2014 (2014-10-02) * Absätze [0013] – [0015], [0032], [0033], [0036], [0042], [0049], [0054], [0102] – [0146]; Abbildungen 2-7 * ----- | 1-14 | INV. G01R33/483 G01R33/54 G01R33/24 G01R33/50 |
| A | DING BELINDA ET AL: "Parallel transmit (pTx) with online pulse design for task-based fMRI at 7 T", MAGNETIC RESONANCE IMAGING, ELSEVIER SCIENCE, TARRYTOWN, NY, US, Bd. 93, 19. Juli 2022 (2022-07-19), Seiten 163-174, XP087174266, ISSN: 0730-725X, DOI: 10.1016/J.MRI.2022.07.003 [gefunden am 2022-07-19] * das ganze Dokument * ----- | 1-14 | |

RECHERCHIERTE
SACHGEBIETE (IPC)

G01R

Der vorliegende Recherchenbericht wurde für alle Patentansprüche erstellt

| Recherchenort | Abschlußdatum der Recherche | Prüfer |
|---|---|---|
| München | 11. Dezember 2023 | Faber-Jurk, Sonja |

EPO FORM 1503 03.82 (P04C03)

**EP 4 484 993 A1**

## ANHANG ZUM EUROPÄISCHEN RECHERCHENBERICHT
## ÜBER DIE EUROPÄISCHE PATENTANMELDUNG NR.

EP 23 18 1787

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

11-12-2023

| Im Recherchenbericht angeführtes Patentdokument | Datum der Veröffentlichung | Mitglied(er) der Patentfamilie | Datum der Veröffentlichung |
|---|---|---|---|
| DE 102013205785 A1 | 02-10-2014 | CN 104101849 A | 15-10-2014 |
| | | DE 102013205785 A1 | 02-10-2014 |
| | | JP 6406851 B2 | 17-10-2018 |
| | | JP 2014200682 A | 27-10-2014 |
| | | KR 20140120281 A | 13-10-2014 |
| | | US 2014292333 A1 | 02-10-2014 |

EPO FORM P0461

Für nähere Einzelheiten zu diesem Anhang : siehe Amtsblatt des Europäischen Patentamts, Nr.12/82